Europäisches Patentamt

**European Patent Office**

**Office européen des brevets**

(11) Veröffentlichungsnummer: **0 111 173**

**A2**

(12) **EUROPÄISCHE PATENTANMELDUNG**

(21) Anmeldenummer: **83111260.2**

(22) Anmeldetag: **11.11.83**

(51) Int. Cl.³: **H 03 G 3/20**
**H 03 G 5/24, G 08 C 23/00**

(30) Priorität: **12.11.82 DE 3241858**

(43) Veröffentlichungstag der Anmeldung:
**20.06.84 Patentblatt 84/25**

(84) Benannte Vertragsstaaten:
**AT FR GB IT NL SE**

(71) Anmelder: **Deutsche Thomson-Brandt GmbH**
**Hermann-Schwer-Strasse 3**
**D-7730 Villingen-Schwenningen(DE)**

(72) Erfinder: **Gleim, Günter**
**Terra Wohnpark 8**
**D-7730 Villingen 24(DE)**

(72) Erfinder: **Baas, Dieter**
**Sofienstrasse 10**
**D-7640 Kehl-Auenheim(DE)**

(54) **Schaltungsanordnung zur Verstärkungsregelung von Vorverstärkerstufen.**

(57) Schaltungsanordnung zur Verstärkungsregelung von Vorverstärkerstufen insbesondere von Empfängern für drahtlos übertragene Fernsteuersignale. Das Regelsignal wird auf einen Schwingkreis geschaltet, welches diesen bedämpft, so daß an diesem nur noch Nutzsignale entstehen können, Störsignale dagegen werden eliminiert.

Fig. 1

Deutsche Thomson-Brandt GmbH
Postfach 2060
7730 Villingen-Schwenningen

0111173

11. November 1982

T-PA 421

$\mathcal{1}$

## PATENTANMELDUNG

---

Schaltungsanordnung zur Verstärkungsregelung
von Vorverstärkerstufen.

---

### Stand der Technik

Die Erfindung geht aus von einer Schaltungsanordnung
zur Verstärkungsregelung von Vorverstärkerstufen,
insbesondere von Empfängern für drahtlos übertragene
Fernsteuersignale. Derartige Verstärker erhalten
eine in dem Empfangsgerät erzeugte Betriebsspannung,
die oftmals sehr niedrig ist. Dies bedeutet jedoch,
daß diese Verstärker leicht übersteuert werden
können. Störimpulse können den Verstärker derart
in die Begrenzung steuern, daß ein Nutz-Signal nicht
mehr verarbeitet werden kann. Es ist deshalb eine
automatische Verstärkungsregelung notwendig. Die am
Ausgang des Verstärkers abgenommene Spannung wird
an eine Stufe zur Erzeugung einer Regelspannung
gelegt. Diese Regelspannung wird auf den Eingang

Deutsche Thomson-Brandt GmbH
Postfach 2060
7730 Villingen-Schwenningen

des Verstärkers zurückgeführt (TDA 4050 B). Dies hat
jedoch den Nachteil, daß auch die Nutzsignale gegengekoppelt sind. Wenn in einem Verstärker der oben
betriebenen Art ein auf die Nutzsignale abgestimmter
Schwingkreis zur Selektierung der Nutzsignale geschaltet ist, können Störimpulse die nahe bei der
Resonanzfrequenz des Schwingkreises liegen, diesen
noch anregen, da die Güte des Kreises hoch gewählt
ist.

## Aufgabe
-------

Der Erfindung liegt deshalb die Aufgabe zugrunde,
eine geregelte Verstärkerschaltung zum Empfang von
Fernsteuersignalen derart aufzubauen, daß Störimpulse den Schwingkreis nicht anregen können, auch
wenn diese größer sind als das empfangene Nutz-
signal. Diese Aufgabe wird durch die Maßnahme des
Patentanspruchs gelöst.

## Beschreibung
------------

Nachstehend soll an einem Ausführungsbeispiel das
Wesentliche der Erfindung erläutert werden.

Deutsche Thomson-Brandt GmbH
Postfach **0111173**
7730 Villingen-Schwenningen

11. November 1982

T-PA 421

Figur 1 zeigt die Erfindung in einem Blockschaltbild.
Figur 2 zeigt Signalspannungen a-d zur Erläuterung
der Wirkungsweise der angemeldeten Schaltungsanordnung.

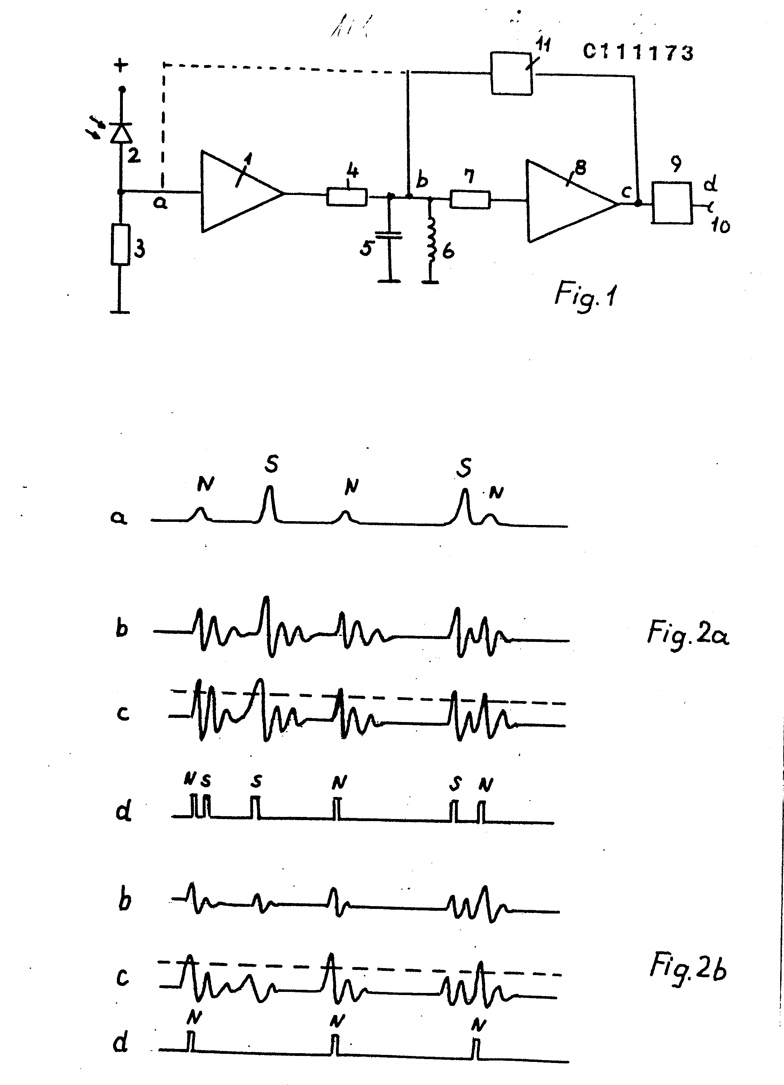

In Figur 1 ist ein Vorverstärker dargestellt, der
zum Empfang impulsförmiger Lichtsignale geeignet ist.
Hierzu ist an den Eingang einer ersten Verstärkerstufe
1 ein lichtempfindliches Element 2 in Serie zu einem
Widerstand 3 geschaltet. Über einen Widerstand 4 gelangt das Empfangssignal an den aus dem Kondensator 5
und der Spule 6 gebildeten Schwingkreis hoher Güte.
Über den Widerstand 7 wird das Signal an den Eingang
des zweiten Verstärkers 8 geschaltet, an dessen
Ausgang ein Schwellschalter 9 angeschlossen ist,
über welchen die Signale an den Ausgang 10 gelangen.
Vom Ausgang der zweiten Verstärkerstufe 8 wird eine
Spannung abgenommen, die über eine Regelstufe 11 den
Schwingkreis 5,6 in ihn bedämpfender Weise beeinflußt.
Dies kann dadurch geschehen, daß dem Schwingkreis ein
Widerstand parallel geschaltet wird oder daß eine
Gleichspannung angelegt wird, so daß sich die Güte
derart ändert, daß die Nutzsignale mit noch genügender
Größe übertragen werden, Störsignale jedoch keine
wesentlichen Spannungsanteile mehr liefern, so daß
sie von dem Schwellwertschalter 9 nicht mehr durchgelassen werden.

- 5 -

Deutsche Thomson Brandt GmbH
Postfach 2060
7730 Villingen-Schwenningen

0111173

4

Mit der Figur 2 soll nachstehend die Wirkungsweise
der angemeldeten Schaltungsanordnung erläutert
werden. Dazu sind die an gekennzeichneten Punkten
a-d liegenden Spannungen in Figur 2a und b aufgetragen.

Figur 2a bezieht sich auf die Verstärkungsregelung
mit einer Schaltung nach dem Stand der Technik, bei
welcher das Regelsignal vom Ausgang c auf den Eingang
a zurückgeführt ist, wie dies gestrichelt in der
Figur 1 angedeutet ist. Figur 2a zeigt bei a ein
mit Störimpulsen S behaftetes Fernsteuersignal N.
Die Impulse werden verstärkt und stoßen den Schwingkreis an. Es ergibt sich bei b ein Signalverlauf b,
der verstärkt bei c auftritt. Der Schwellwertschalter
9 erzeugt ein Signal d am Ausgang 10. Man erkennt an
Figur 2a, daß jeder Störimpuls S an den Ausgang 10
gelangt.
Durch die Maßnahme nach der Erfindung wird in Abhängigkeit vom Ausgangssignal bei c der Schwingkreis
5,6 bedämpft, so daß nur noch die Fernsteuersignale N
den Schwingkreis anregen können. Nach Verstärkung und
Auskopplung über den Schwellwertschalter 9 ergeben sich
am Ausgang 10 bei d nur noch Fernsteuersignale N, die
von den Störimpulsen S befreit sind.

Der Vorteil der Schaltung liegt darin begründet, daß
durch die bessere Störunterdrückung eine Größere Reichweite des Fernsteuersystems erzielt werden kann.

- 6 -

Deutsche Thomson-Brandt GmbH
Postfach 2000
7730 Villingen-Schwenningen

0111173

11. November 1982

T-PA 421

Patentanspruch

---

Schaltungsanordnung zur Verstärkungsregelung von
Vorverstärkerstufen, insbesondere von Empfängern
für drahtlos übertragene Fernsteuersignale mit
einem an den Eingang eines ersten Verstärkers
angeschalteten lichtempfindlichen Element und
einem zur Selektierung der Fernsteuersignale
dienenden Schwingkreis, d a d u r c h    g e -
k e n n z e i c h n e t, daß der Schwingkreis
(5,6) zwischen den Ausgang des ersten Verstärkers
(1) und den Eingang eines zweiten Verstärkers
(8) geschaltet ist und das erzeugte Regelsignal
auf den Schwingkreis (5,6) in diesen bedämpfenderweise geschaltet ist.

Fig.1

C111173

Fig.2a

Fig.2b